(19) Europäisches Patentamt
European Patent Office
Office européen des brevets

(11) Publication number: 0 327 341 B1

(12) # EUROPEAN PATENT SPECIFICATION

(45) Date of publication of patent specification: 20.07.94 (51) Int. Cl.$^5$: G03F 7/012

(21) Application number: 89300972.0

(22) Date of filing: 01.02.89

(54) **Improvements in or relating to radiation-sensitive compositions.**

(30) Priority: 03.02.88 GB 8802314

(43) Date of publication of application:
09.08.89 Bulletin 89/32

(45) Publication of the grant of the patent:
20.07.94 Bulletin 94/29

(84) Designated Contracting States:
AT BE CH DE ES FR GB IT LI LU NL SE

(56) References cited:
EP-A- 0 048 876
DE-A- 2 733 005
FR-A- 2 156 906

(73) Proprietor: E.I. DU PONT DE NEMOURS AND COMPANY
1007 Market Street
Wilmington Delaware 19898(US)

(72) Inventor: Etherington, Terence
50 Belle Vue Avenue
Roundhay
Leeds LS8 2NN West Yorkshire(GB)
Inventor: Kolodziejczyk, Victor
6 Southcroft Avenue
Birkenshaw
Bradford BD11 2OD West Yorkshire(GB)

(74) Representative: Sunderland, James Harry et al
HASELTINE LAKE & CO
Hazlitt House
28 Southampton Buildings
Chancery Lane
London WC2A 1AT (GB)

EP 0 327 341 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to radiation sensitive compounds and more particularly, but not exclusively, is concerned with radiation-sensitive compounds for use in the manufacture of radiation-sensitive plates for lithographic printing plate production.

Radiation-sensitive plates comprising a substrate coated with a radiation-sensitive composition are well known in the production of lithographic and other types of printing plate, and similar compositions are used for other purposes such as photoresists.

In use, the composition is image-wise exposed to radiation so that parts of the composition are struck by radiation and parts are not. The radiation and non-radiation struck parts have differing solubilities in developer liquids, and thus the more soluble parts can be selectively removed by application of such a liquid.

As is well known, radiation-sensitive compounds are considered to be either positive working or negative working, depending on whether the affect of the radiation is to increase or decrease the solubility of the compounds. Negative working compounds commonly are based on photo cross-linkable compounds (e.g. cinnamate type materials) or the so called diazo resins. The former provide printing plates having a good printing run length which is capable of being substantially increased by baking the exposed compound. They also have a reasonable sensitivity. However, they have the disadvantage, which is becoming increasingly important, that an organic solvent has to be used as the developer liquid. Diazo resins are of comparable sensitivity but have the disadvantage that the printing run length is substantially lower, and moreover, they cannot be baked to increase the run length of printing plates made therefrom. Their main advantage is that they can be developed in an aqueous-based developer liquid.

EP-A-0 048 876 teaches a polymer including pendant alkenyl- or cycloalkenyl-sulphonyl urethane groups. The polymer is used in a photosentive mixture, together with a photosensitive compound such as an azido compound. GB-A-1 377 747 discloses a light sensitive polymer having azide substituted aromatic ester groups. When used in lithographic printing processes, after exposure, the mixture of EP-A-0 048 876 may be developed with an aqueous developer, whereas the polymer of GB-A-1 377 747 must be developed with a non-aqueous developer. Neither EP-A-0 048 876 nor GB-A-1 377 747 contains any suggestion that sulphonyl urethane groups and azide substituted aromatic ester groups may be provided on the same polymer and both GB-A-1 377 747 and EP-A 0 048 876 are unconcerned with baking the exposed compound to increase the printing run length.

It is an object of the present invention to provide a radiation-sensitive compound which, without loss in sensitivity, has the aqueous developability characteristics of the diazo resins, and the run length characteristics, including the capability of being baked, of the photo cross-linkable compounds.

According to one aspect of the invention, there is provided a radiation-sensitive polymer including a plurality of azide-substituted aromatic ester groups and a plurality of sulphonyl urethane groups.

According to another aspect of the present invention there is provided a process for the production of the above polymer which process comprises providing a polymer including a plurality of hydroxyl groups and optionally epoxide groups; reacting an azide-substituted aromatic carboxylic acid, or esterforming derivative thereof, with some of the hydroxyl groups and/or at least some of the epoxide groups if present; and reacting a sulphonyl isocyanate with at least some of the hydroxyl groups.

Generally, the radiation-sensitive compound may be prepared by mixing together solutions in suitable solvents of appropriate molar quantities of the starting polymer and the sulphonyl isocyanate, continuing the reaction until no residual isocyanate is present, adding an appropriate molar quantity of azide-substituted acid or ester forming derivative thereof, carrying out the reaction for 1-6 hours at a temperature of from ambient to 60 °C, filtering off insoluble by-products, isolating by drowning-out into a suitable non-solvent, filtering, washing as necessary, and drying.

The ester-forming derivative of the azide-substituted aromatic carboxylic acid may be the acid chloride or acid anhydride.

Preferably the azide substituted aromatic carboxylic acid has the general formula

$$N_3\text{-}R\text{-}(CR^1 = CR^2)a\text{-}(CR^3 = CR^4)_bCOOH$$

wherein a, b, R, $R^1$, $R^2$, $R^3$ and $R^4$ have the meanings given below and preferably the sulphonyl isocyanate has the general formula

$$R^6 - SO_2 - N = C = O$$

wherein $R^6$ has the meaning given below.

Particulary preferred polymers are:-

1. Poly (vinyl acetate) or copolymers of vinyl acetate with other vinyl monomers and which have been at least partially saponified, and esters or acetal derivatives of such saponified materials. Examples of such polymers are poly (vinyl alcohols) having between 80% and 100% (by weight) vinyl alcohol units and molecular weights of approximately 50,000 and poly (vinyl butyrals) and other poly (vinyl acetals) having at least 10% by weight of vinyl alcohol units and molecular weights in the range 20,000 to 80,000.
2. Epoxy resins which are condensation products of epichlorohydrin with aromatic hydroxy compounds such as bisphenol A and which have molecular weights in the range of 900 to 5,000.
3. Poly (meth) acrylate esters and in particular those derived from 2-hydroxy propyl methacrylate or 2-hydroxy ethyl methacrylate.
4. Copolymers containing free hydroxyl groups such as styrene-allyl alcohol copolymers;
5. Novolak resins which are the condensation products of phenols or cresols with formaldehyde.
6. Polymers derived from vinyl phenols.

In a preferred embodiment, the azide-substituted aromatic ester groups are of the general formula:

$N_3\text{-R-}(CR^1=CR^2)_a\text{-}(CR^3=CR^4)_b\text{-COO-}$

attached to carbon atoms of the polymer wherein a and b are zero or 1 and a + b is at least 1; R represents an aromatic radical optionally substituted with a group or groups additional to the azido group; and $R^1$, $R^2$, $R^3$ and $R^4$, which may be the same or different, represent halogen atoms, hydrogen atoms, cyano groups, alkyl groups, aryl groups, alkoxy groups, aryloxy groups, aralkyl groups or aralkoxy groups provided that at least one of the groups $R^1$ to $R^4$ represents a halogen atom or a cyano group.

Particularly preferred are ester groups derived from the following acids:-

4-azido-α-bromo-δ-chlorocinnamylidene acetic acid
4-azido-α-chlorocinnamylidene acetic acid
4-azido-α-cyano-δ-chlorocinnamylidene acetic acid
4-azido-α-cyano-cinnamylidene acetic acid
3-azido-benzylidene-α-cynaoacetic acid
4-azido-2-chlorobenzylidene-α-cyanoacetic acid
4-azido-3,5-dibromobenzylidene-α-cyanoacetic acid
3-azido-4-methyl-benzylidene-α-cyanoacetic acid
3-azido-4-methoxybenzylidene-α-cyanoacetic acid
4-azido-benzylidene-α-bromo-cyanoacetic acid
4-azidobenzylidene-α-cyanoacetic acid
4-azido-3-chlorobenzylidene-α-cyanoacetic acid
and azide substituted N-phenyl anthranilic acids such as

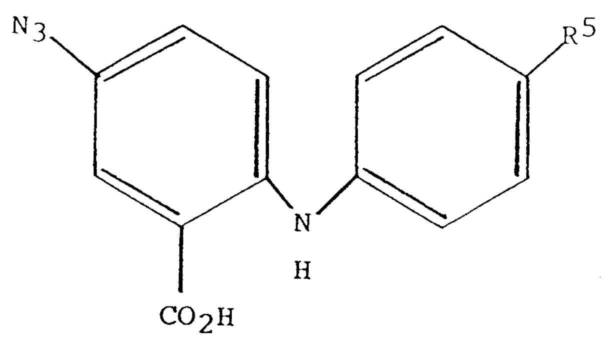

where $R^5$ = hydrogen, methyl, methoxy or chlorine.

Optionally, the polymer may also have attached thereto ester groups derived from non-azido-group containing aliphatic or aromatic carboxylic acids such as propionic acid, benzoic acid or octanoic acid.

If the acids themselves are used to esterify the hydroxy and/or epoxide groups, reagents such as di-(cyclohexyl) carbodiimide may be used to promote esterification. If the acid chloride or acid anhydride is used, then suitable acid binders or catalysts may be required, such as pyridine, sodium carbonate or sodium acetate.

In a preferred embodiment, the sulphonyl urethane groups are of the general formula:

$$R^6 - SO_2 - NH - \overset{\overset{\large O}{\|}}{C} - O -$$

attached to carbon atoms of the polymer
where $R^6$ may be alkyl, alkoxy, aryloxy, or a tertiary amine group substituted with an alkyl or acyl radical having 1-6 C atoms or an aryl radical having 6-10 C atoms.

Particularly preferred are sulphonyl urethane groups derived from benzene sulphonyl isocyanate, p-chlorobenzene sulphonyl isocyanate, p-toluene sulphonyl isocyanate and propenyl sulphonyl isocyanate.

Whilst the compounds of the invention may be used as the sole radiation-sensitive compound in compositions for use in the manufacture of printing plates or for use as photoresists, they may be also used in conjunction with other radiation-sensitive compounds.

Accordingly a further aspect of the present invention comprises a radiation-sensitive composition comprising a radiation-sensitive compound as defined above, and at least one other radiation-sensitive compound.

Preferably, said other radiation sensitive compound is a diazo compound such as is defined in European patent specification No. 30862 or as is produced by the condensation of diazo diphenyl amine and formaldehyde.

The following Examples illustrate the invention.

**EXAMPLE 1**

Preparation of the Radiation-Sensitive Compound

40g of poly (vinyl butyral) containing 74% by weight of vinyl butyral units, 2% by weight of vinyl acetate units and 24% by weight of vinyl alcohol units and having an approximate average molecular weight of 30,000, were dissolved in 500 $cm^3$ of anhydrous methyl acetate at $40^\circ C$. To this solution, 28.5g of p-toluene sulphonyl isocyanate (TSI) dissolved in 40 $cm^3$ of methyl acetate were added over the course of 15 minutes at $40^\circ C$. The reaction was allowed to continue for a further hour at $40^\circ C$ with stirring. 13.0g of 4-azidobenzylidene-$\alpha$-cyano acetic acid were added followed by 12.46g of 1,3-dicyclo hexyl carbodiimide (DCC) dissolved in 40 $cm^3$ of methyl acetate and finally 0.1g of 4-dimethylamino pyridine (DMAP). The reaction mixture was then refluxed for 3 hours and then cooled to ambient temperature whilst being stirred. The insoluble 1,3-dicyclo hexyl urea produced was removed by filtration and the filtrate was sprayed into 5 litres of water to isolate the product. The resulting fibrous precipitate was filtered off, washed with 3 litres of aqueous 1% $^w/w$ potassium carbonate solution to remove any free acid and then re-slurried into water 3 times. The final product was dried at $35^\circ C$ to constant weight.

Analysis of the dried product by a combination of HPLC and Gel Permeation Chromatography (GPC), using U.V. detection at both 245 nm and 364 nm, confirmed that very little (< 2% w/w) monomeric materials (i.e. starting materials or their monomeric derivatives) were present. The polymeric component was, however, found to absorb strongly at these wavelengths, thereby confirming that considerable reaction had taken place. Quantification of the aromatic azide containing ester content by UV spectrophotomeric analysis indicated the presence of 13.8 mol % ester. Titration of a THF solution of the product with 0.1M KOH determined an acid value of 65 (mg/g KOH).

These analyses are recorded in Table 1.

Preparation of a Printing Plate

2.6g of the above product and 0.06g of Victoria Pure Blue BO dye were dissolved in 100$cm^3$ of ethylene glycol monomethyl ether. After filtering to remove any solids, the solution was whirler-coated onto a sheet of electrograined and anodised aluminium to give a dry coating weight of 0.7-0.9$gm^{-2}$.

The plate was exposed and developed and the sensitivity and development characteristics are shown in Table 1.

**EXAMPLE 2**

Preparation of a Printing Plate

0.7g of the polymer prepared as in Example 1, 1.9g of a diazo compound as described in Example 1 of European patent specification No. 30862 and 0.06g of Victoria Pure Blue BO were dissolved in ethylene glycol monomethyl ether, and the solution was used to prepare a printing plate as described in Example 1. The sensitivity and developability characteristics are set out in Table 1.

**EXAMPLE 3**

Preparation of the Radiation Sensitive Compound

20g of an epoxy resin obtained by condensing epichlorhydrin and bisphenol A and having a molecular weight of 1400 were dissolved in 115 $cm^3$ of anhydrous methyl acetate and 6.27g of TSI dissolved in $20cm^3$ of methyl acetate were added over a period of 15 minutes at ambient temperature.

The reaction mixture was refluxed for 3 hours and then cooled to ambient temperature. 3.0g of 4-azido benzylidene-$\alpha$-cyano acetic acid, followed by 2.84g of DCC dissolved in $20cm^3$ of methyl acetate and 0.05g of 4-dimethyl amino pyridine were added. The reaction mixture was refluxed for 3 hours and then 2.31g of octanoyl chloride and 1.25g of pyridine were added and the mixture was further refluxed for 2 hours. The final product was recovered as in Example 1 except that the drowning-out step was carried out using propan-2-ol. After drying at 35 °C to constant weight, the product was analysed as in Example 1. The analysis results are recorded in Table 1.

Preparation of a Printing Plate

A printing plate using the above product was prepared in the same way as in Example 1. The characteristics are set out in Table 1.

**EXAMPLE 4**

Preparation of the Radiation Sensitive Compound

10g of the epoxy resin of Example 3 were dissolved in 50 $cm^3$ of dichloromethane. 3.73 $cm^3$ of TSI dissolved in $10cm^3$ of dichloromethane were added to this solution over the course of a 15 minute interval at ambient temperature. The reaction was allowed to continue for a further two and a half hours with stirring. A solution prepared from 2.86g of 4-azido benzylidene-$\alpha$-cyano acetic acid chloride in $25cm^3$ of dichloromethane was added followed by $1.09cm^3$ of pyridine. The reaction mixture was then refluxed for two and a half hours and then cooled to ambient temperature. The insoluble pyridine hydrochloride was removed by filtration and the filtrate was sprayed into $1500cm^3$ of propan-2-ol to isolate the product which was then filtered off, reslurried in $1000cm^3$ of propan-2-ol, filtered again and dried at 35 °C. The product was analysed as in Example 1 and the analysis results recorded in Table 1.

Preparation of a Printing Plate

A printing plate using the above product was prepared in the same way as in Example 1. The characteristics of the printing plate are shown in Table 1.

**EXAMPLES 5 to 16**

Radiation sensitive compounds based on various starting materials were produced by the above methods, analysed according to the description in Example 1 and printing plates prepared. The results are shown in Table 1.

Table 1 gives the following data in addition to the Example number

Column 1: starting polymer type

Type A = polyvinyl butyral containing 74% by weight of vinyl butyral units, 2% by weight of vinyl acetate units and 24% by weight of vinyl alcohol units and having a molecular weight of 30,000
Type B = epoxy resin derived from the condensation of bisphenol A and epichlorhydrin and having a molecular weight of 1400
Type C = polyvinyl butyral containing 80% by weight vinyl butyral units and 20% by weight of vinyl alcohol units and having a molecular weight of 60,000
Type D = cresol formaldehyde resin having a softening temperature of 150-160 °C
Type E = styrene/allyl alcohol co-polymer containing 5-7% by weight hydroxyl groups and having a molecular weight of 2,500

Column 2: azide-substituted acid type, percentage by weight of ester groups present, molar percentage of acid charged

Type 1 = 4-azido benzylidene-α-cyano acetic acid ( λ max 345 nm)
Type 2 = 4-azido benzylidene-α-cyano acetic acid chloride ( λ max 345 nm)
Type 3 = 3-chloro 4 azido benzylidene-α-cyano acetic acid (λ max 348 nm)
Type 4 = 5-azido N-phenyl anthranilic acid ( λmax 356 nm)
Type 5 = 4-azido-α-cyano-δ-chlorocinnamylidene acetic acid ( λ max 375 nm)

Column 3: sulphonyl isocyanate type, acid value, molar percentage of isocyanate charged

Type TSI = toluene sulphonyl isocyanate
Type BSI = benzene sulphonyl isocyanate
Type PSI = propenyl sulphonyl isocyanate
Type CBSI = 4-chloro benzene sulphonyl isocyanate

Column 4: diazo compound type, ratio of diazo to compound of the invention

Type I = as in Example 6 of European patent specification No. 30862
Type II = diazo diphenyl amine-formaldehyde condensate

Column 5: developer type

Type W = an aqueous solution as described in Example 1 of GB Patent Specification No. 2068136
Type X = an aqueous solution of a surfactant containing 7% benzyl alcohol
Type Y = a mixture of a glycol ester and a surfactant as described in Example 8 of GB Patent Specification No. 1220808

Column 6: sensitivity

The sensitivity was determined using an IL 540 photometer marketed by International Light Inc and is the amount of radiation needed to produce, after inking, a solid step 4 when the plate was exposed through a continuous tone step-wedge.

Comparative Examples 1 and 2 in Table 1 give sensitivity and development characteristics for a composition based on a photocross-linkable compound and a diazo resin respectively.

## EXAMPLE 17

Lithographic printing plates based on Examples 1, 2, 3, 6 and 15, and comparative Examples C1 and C2 were tested on a rotary web offset press and the results are shown in Table 2.

## EXAMPLE 18

Examples 1 and 3 were repeated with the inclusion in the respective compositions of 10% w/w of 1,2-benzanthraquinone as sensitiser. It was found that a 30% increase in sensitivity was produced.

TABLE 1

| | 1 | 2 | | | 3 | | | 4 | | 5 | 6 |
|---|---|---|---|---|---|---|---|---|---|---|---|
| Example No. | Type of Starting Polymer | Azide acid Type | % Ester | Mol % chgd | Sulphonyl Isocyanate Type | Acid Value | Mol % chgd | Diazo Compound Type | Ratio | Developer Type | Sensitivity (mJ $cm^{-2}$) |
| 1 | A | 1 | 13.8 | 30 | TSI | 65 | 66 | - | - | W | 221 |
| 2 | A | 1 | 13.8 | 30 | TSI | 65 | 66 | I | 2.7:1 | W | 400 |
| 3 | B | 1 | 12.6 | 45 | TSI | 44 | 60 | - | - | X | 560 |
| 4 | B | 2 | 16.2 | 30 | TSI | 49 | 60 | - | - | X | 494 |
| 5 | B | 1 | 13.4 | 45 | BSI | 37 | 60 | I | 2.7:1 | X | 640 |
| 6 | A | 1 | 18.3 | 55 | TSI | 56 | 55 | I | 2.7:1 | X | 125 |
| 7 | D | 3 | 13.1 | 30 | TSI | 75 | 90 | II | 2.7:1 | W | 800 |
| 8 | C | 1 | 13.8 | 32 | PSI | 57 | 66 | - | - | W | 234 |
| 9 | E | 1 | 10.9 | 60 | BSI | 62 | 30 | I | 2.7:1 | W | 300 |

TABLE 1 cont...

| | 1 | 2 | | | 3 | | | 4 | | 5 | 6 |
|---|---|---|---|---|---|---|---|---|---|---|---|
| | | Azide acid | | | Sulphonyl Isocyanate | | | Diazo Compound | | | |
| Example No. | Type of Starting Polymer | Type | % Ester | Mol % chgd | Type | Acid Value | Mol % chgd | Type | Ratio | Developer Type | Sensitivity (mJ $cm^{-2}$) |
| 10 | E | 1 | 10.9 | 60 | BSI | 62 | 30 | I | 1:2 | W | 400 |
| 11 | A | 4 | 10.1 | 30 | BSI | 62 | 66 | - | - | W | 300 |
| 12 | A | 3 | 12.4 | 30 | TSI | 66 | 66 | - | - | W | 260 |
| 13 | A | 1 | 13.9 | 30 | CBSI | 39 | 60 | II | 1:2 | X | 200 |
| 14 | A | 1 | 13.8 | 30 | TSI | 65 | 66 | II | 1:2 | X | 200 |
| 15 | A | 3 | 12.4 | 30 | TSI | 66 | 66 | I | 1:2 | W | 200 |
| 16 | A | 5 | 11.7 | 40 | TSI | 60 | 66 | I | 1:2 | X | 220 |
| C1 | B | 2 | 30 | 70 | - | - | - | - | - | Y | 600 |
| C2 | - | - | - | - | - | - | - | II | - | W | 800 |

TABLE 2

| Example No. | No. of Impressions (unbaked) | No. of Impressions (baked) |
|---|---|---|
| 1 | 75 x $10^3$ | 97 x $10^3$ |
| 2 | 70 x $10^3$ | 90 x $10^3$ |
| 3 | 75 x $10^3$ | ≧ 130 x $10^3$ |
| 6 | 70 x $10^3$ | 90 x $10^3$ |
| 15 | 70 x $10^3$ | 95 x $10^3$ |
| C1 | 90 x $10^3$ | ≧ 130 x $10^3$ |
| C2 | 30 x $10^3$ | 30 x $10^3$ |

The baking was carried out at 200 °C for 10 minutes in accordance with the treatment described in GB Patent No. 1513368.

**Claims**
**Claims for the following Contracting States : AT, BE, FR, DE, IT, LU, NL, SE, CH, GB**

**1.** A radiation-sensitive polymer characterised in that the polymer includes a plurality of azide-substituted aromatic ester groups and a plurality of sulphonyl urethane groups.

**2.** A polymer as claimed in claim 1 wherein the azide-substituted aromatic ester groups are of the general formula:

$N_3$-R-($CR^1 = CR^2$)$_a$-($CR^3 = CR^4$)$_b$-COO-

attached to carbon atoms of the polymer wherein a and b are zero or 1 and a + b is at least 1; R represents an aromatic radical optionally substituted with a group or groups additional to the azido group; and $R^1$, $R^2$, $R^3$ and $R^4$, which may be the same or different, represent halogen atoms, hydrogen atoms, cyano groups, alkyl groups, aryl groups, alkoxy groups, aryloxy groups, aralkyl groups or aralkoxy groups provided that at least one of the groups $R^1$ to $R^4$ represents a halogen atom or a cyano group.

**3.** A polymer as claimed in claim 1 or 2 wherein the ester groups are derived from one or more of the following acids:-
4-azido-α-bromo-δ-chlorocinnamylidene acetic acid
4-azido-α-chlorocinnamylidene acetic acid
4-azido-α-cyano-δ-chlorocinnamylidene acetic acid
4-azido-α-cyano-cinnamylidene acetic acid
3-azido-benzylidene-α-cynaoacetic acid
4-azido-2-chlorobenzylidene-α-cyanoacetic acid
4-azido-3,5-dibromobenzylidene-α-cyanoacetic acid
3-azido-4-methyl-benzylidene-α-cyanoacetic acid
3-azido-4-methoxybenzylidene-α-cyanoacetic acid
4-azido-benzylidene-α-bromo-cyanoacetic acid
4-azidobenzylidene-α-cyanoacetic acid
4-azido-3-chlorobenzylidene-α-cyanoacetic acid
and an azide substituted N-phenyl anthranilic acid.

**4.** A polymer as claimed in claim 3 wherein the azide substituted N-phenyl anthranilic acid has the formula

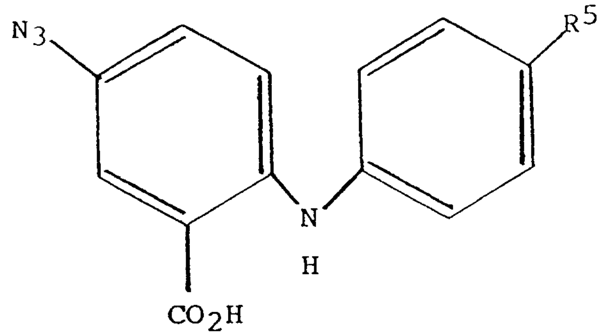

where $R^5$ = hydrogen, methyl, methoxy or chlorine.

5. A polymer as claimed in any one of claims 1 to 4 wherein the polymer has attached thereto ester groups derived from non-azido-group containing aliphatic or aromatic carboxylic acids.

6. A polymer as claimed in any one of claims 1 to 5 wherein the sulphonyl urethane groups are of the general formula:

$$R^6 - SO_2 - NH - \overset{\overset{O}{\|}}{C} - O -$$

attached to carbon atoms of the polymer
where $R^6$ may be alkyl, alkoxy, aryloxy, or a tertiary amine group substituted with an alkyl or acyl radical having 1-6 C atoms or an aryl radical having 6-10 C atoms.

7. A polymer as claimed in claim 6 wherein the sulphonyl urethane are groups derived from benzene sulphonyl isocyanate, p-chlorobenzene sulphonyl isocyanate, p-toluene sulphonyl isocyanate and propenyl sulphonyl isocyanate.

8. A process for the production of a radiation sensitive polymer of claim 1, characterized in that the process comprises providing a polymer having hydroxyl groups and optionally epoxide groups and reacting an azide-substituted aromatic carboxylic acid, or ester-forming derivative thereof, with some of the hydroxyl groups and/or at least some of the epoxide groups if present; and reacting a sulphonyl isocyanate with at least some of the remaining hydroxyl groups.

9. A process as claimed in claim 8 wherein the ester-forming derivative of the azide-substituted aromatic carboxylic acid is the acid chloride or acid anhydride.

10. A process according to claims 8 or 9 wherein the polymer is a poly(vinyl acetate) or a copolymer of vinyl acetate with other vinyl monomers and which have been at least partially saponified, and esters or acetal derivatives of such saponified materials, an epoxy resin, a poly(meth)acrylate ester, a copolymer containing free hydroxyl groups, a Novolak resin or a polymer derived from vinyl phenols.

11. A radiation-sensitive composition comprising a radiation-sensitive polymer as defined in any one of claims 1 to 7, and at least one other radiation-sensitive compound.

12. A radiation sensitive composition as claimed in claim 11 wherein the other radiation sensitive compound is a diazo compound or a compound produced by the condensation of diazo diphenyl amine and formaldehyde.

**Claims for the following Contracting State : ES**

1. A process for the production of a radiation sensitive polymer characterised in that the process comprises providing a polymer having hydroxyl groups and optionally epoxide groups and reacting an azide-substituted aromatic carboxylic acid, or ester-forming derivative thereof, with some of the hydroxyl groups and/or at least some of the epoxide groups if present; and reacting a sulphonyl isocyanate with at least some of the remaining hydroxyl groups.

2. A process as claimed in claim 1 wherein the ester-forming derivative of the azide-substituted aromatic carboxylic acid is the acid chloride or acid anhydride.

3. A process according to claims 1 or 2 wherein the polymer is a poly(vinyl acetate) or a copolymer of vinyl acetate with other vinyl monomers and which have been at least partially saponified, and esters or acetal derivatives of such saponified materials, an epoxy resin, a poly(meth)acrylate ester, a copolymer containing free hydroxyl groups, a Novolak resin or a polymer derived from vinyl phenols.

4. A process as claimed in claim 1, 2 or 3 wherein the azide-substituted aromatic carboxylic acid has the general formula:

$$N_3\text{-}R\text{-}(CR^1 = CR^2)_a\text{-}(CR^3 = CR^4)_b\text{-}COOH\text{-}$$

wherein a and b are zero or 1 and a + b is at least 1; R represents an aromatic radical optionally substituted with a group or groups additional to the azido group; and $R^1$, $R^2$, $R^3$ and $R^4$, which may be the same or different, represent halogen atoms, hydrogen atoms, cyano groups, alkyl groups, aryl groups, alkoxy groups, aryloxy groups, aralkyl groups or aralkoxy groups provided that at least one of the groups $R^1$ to $R^4$ represents a halogen atom or a cyano group.

5. A process as claimed in claim 4 wherein the acid is
4-azido-α-bromo-δ-chlorocinnamylidene acetic acid
4-azido-α-chlorocinnamylidene acetic acid
4-azido-α-cyano-δ-chlorocinnamylidene acetic acid
4-azido-α-cyano-cinnamylidene acetic acid
3-azido-benzylidene-α-cynaoacetic acid
4-azido-2-chlorobenzylidene-α-cyanoacetic acid
4-azido-3,5-dibromobenzylidene-α-cyanoacetic acid
3-azido-4-methyl-benzylidene-α-cyanoacetic acid
3-azido-4-methoxybenzylidene-α-cyanoacetic acid
4-azido-benzylidene-α-bromo-cyanoacetic acid
4-azidobenzylidene-α-cyanoacetic acid
4-azido-3-chlorobenzylidene-α-cyanoacetic acid
or an azide substituted N-phenyl anthranilic acid.

6. A process as claimed in claim 5 wherein the azide substituted N-phenyl anthranilic acid has the formula

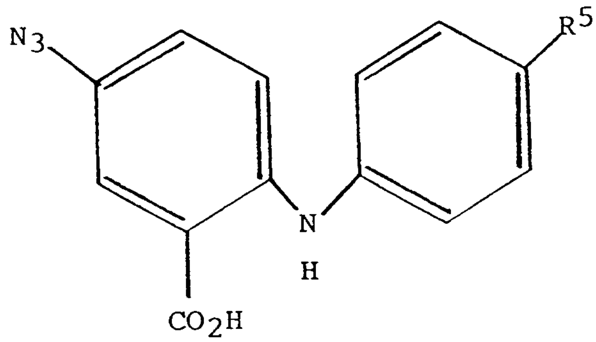

where $R^5$ = hydrogen, methyl, methoxy or chlorine.

**7.** A process as claimed in any preceding claim wherein some of the hydroxyl groups and/or epoxide groups are reacted with a non-azido-group containing aliphyatic or aromatic carboxylic acid.

**8.** A process as claimed in any one of claims 1 to 7 wherein the sulphonyl isocyanate has the general formula:

$R^6$ - $S0_2$ - N = C = O

where $R^6$ may be alkyl, alkoxy, aryloxy, or a tertiary amine group substituted with an alkyl or acyl radical having 1-6 C atoms or an aryl radical having 6-10 C atoms.

**9.** A process according to claim 8 wherein the sulphonyl isocyanate is benzene sulphonyl isocyanate, p-chlorobenzene sulphonyl isocyanate, p-toluene sulphonyl isocyanate or propenyl sulphonyl isocyanate.

**Patentansprüche**
**Patentansprüche für folgende Vertragsstaaten : AT, BE, FR, DE, IT, LU, NL, SE, CH, GB**

**1.** Strahlungsempfindliches Polymer, dadurch gekennzeichnet, daß das Polymer eine Anzahl Azid-substituierter, aromatischer Estergruppen und eine Anzahl Sulfonylurethangruppen enthält.

**2.** Polymer nach Anspruch 1, wobei die Azid-substituierten, aromatischen Estergruppen die allgemeine Formel

$N_3$-R-($CR^1 = CR^2)_a$-($CR^3 = CR^4)_b$-COO-

haben und an Kohlenstoffatome des Polymers gebunden sind, wobei a und b Null oder 1 sind und a + b mindestens 1 ist; R ein aromatisches Radikal ist, das gegebenenfalls zusätzlich zur Azidogruppe mit ein oder mehreren Gruppen substituiert ist; und $R^1$, $R^2$, $R^3$ und $R^4$, die gleich oder verschieden sein können, Halogenatome, Wasserstoffatome, Cyanogruppen, Alkylgruppen, Arylgruppen, Alkoxygruppen, Aryloxygruppen, Aralkylgruppen oder Aralkoxygruppen sind, vorausgesetzt, daß mindestens eine der Gruppen $R^1$ bis $R^4$ ein Halogenatom oder eine Cyanogruppe ist.

**3.** Polymer nach Anspruch 1 oder 2, wobei die Estergruppen von einer oder mehreren der folgenden Säuren stammen:
4-Azido-α-brom-δ-chlorcinnamylidenessigsäure
4-Azido-α-chlorcinnamylidenessigsäure
4-Azido-α-cyano-δ-chlorcinnamylidenessigsäure
4-Azido-α-cyanocinnamylidenessigsäure
3-Azido-benzyliden-α-cyanoessigsäure
4-Azido-2-chlorbenzyliden-α-cyanoessigsäure
4-Azido-3,5-dibrombenzyliden-α-cyanoessigsäure
3-Azido-4-methylbenzyliden-α-cyanoessigsäure
3-Azido-4-methoxybenzyliden-α-cyanoessigsäure
4-Azidobenzyliden-α-bromcyanoessigsäure
4-Azidobenzyliden-α-cyanoessigsäure
4-Azido-3-chlorbenzyliden-α-cyanoessigsäure
und eine Azid-substituierte N-Phenylanthranilsäure.

**4.** Polymer nach Anspruch 3, wobei die Azid-substituierte N-Phenylanthranilsäure die Formel hat:

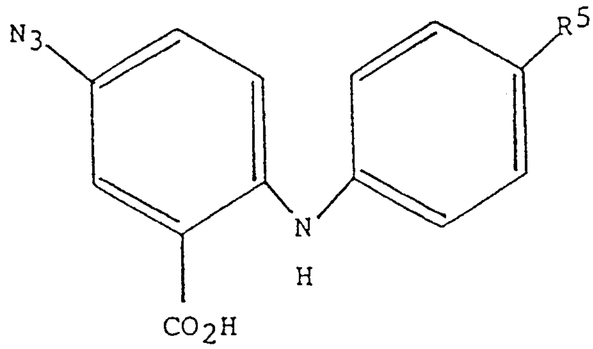

worin $R^5$ Wasserstoff, Methyl, Methoxy oder Chlor ist.

**5.** Polymer nach einem der Ansprüche 1 bis 4, wobei Estergruppen mit dem Polymer verbunden sind, die von aliphatischen oder aromatischen Carbonsäuren stammen, die keine Azidogruppe enthalten.

**6.** Polymer nach einem der Ansprüche 1 bis 5, wobei die Sulfonylurethangruppen die allgemeine Formel aufweisen:

$$R^6 - SO_2 - NH - \overset{\overset{\displaystyle O}{\|}}{C} - O -$$

die an Kohlenstoffatome des Polymers gebunden sind, worin $R^6$ eine Alkyl-, Alkoxy-, Aryloxy- oder tertiäre Amingruppe sein kann, die mit einem Alkyl- oder Acylradikal mit 1 bis 6 C-Atomen oder einem Arylradikal mit 6 bis 10 C-Atomen substituiert ist.

**7.** Polymer nach Anspruch 6, wobei die Sulfonylurethangruppen von Benzolsulfonylisocyanat, p-Chlorbenzolsulfonylisocyanat, p-Toluolsulfonylisocyanat und Propenylsulfonylisocyanat stammen.

**8.** Verfahren zur Herstellung eines strahlungsempfindlichen Polymers nach Anspruch 1, dadurch gekennzeichnet, daß das Verfahren umfaßt: Bereitstellen eines Polymers mit Hydroxylgruppen und gegebenenfalls Epoxidgruppen und Umsetzen einer Azid-substituierten, aromatischen Carbonsäure oder eines esterbildenden Derivats davon mit einem Teil der Hydroxylgruppen und/oder mindestens einem Teil der Epoxidgruppen, falls vorhanden; und Umsetzen eines Sulfonylisocyanats mit mindestens einem Teil der restlichen Hydroxylgruppen.

**9.** Verfahren nach Anspruch 8, worin das esterbildende Derivat der Azid-substituierten, aromatischen Carbonsäure das Säurechlorid oder Säureanhydrid ist.

**10.** Verfahren nach Anspruch 8 oder 9, worin das Polymer Poly(vinylacetat) ist oder ein Copolymer von Vinylacetat und anderen Vinylmonomeren, die mindestens teilverseift sind, und Estern oder Acetalderivaten dieser verseiften Materialien, ein Epoxyharz, ein Poly(meth)acrylatester, ein Copolymer, das freie Hydroxylgruppen enthält, ein Novolakharz oder ein von Vinylphenolen stammendes Polymer.

**11.** Strahlungsempfindliche Zusammensetzung, die ein strahlungsempfindliches Polymer nach einem der Ansprüche 1 bis 7 und mindestens eine weitere strahlungsempfindliche Verbindung enthält.

**12.** Strahlungsempfindliche Zusammensetzung nach Anspruch 11, worin die weitere strahlungsempfindliche Verbindung eine Diazoverbindung oder eine Verbindung ist, die durch Kondensation von Diazodiphenylamin und Formaldehyd hergestellt wird.

**Patentansprüche für folgenden Vertragsstaat : ES**

1. Verfahren zur Herstellung eines strahlungsempfindliches Polymers, dadurch gekennzeichnet, daß dieses Verfahren umfaßt: Bereitstellen eines Polymers mit Hydroxylgruppen und gegebenenfalls Epoxidgruppen und Umsetzen einer Azid-substituierten, aromatischen Carbonsäure oder eines esterbildenden Derivats davon mit einem Teil der Hydroxylgruppen und/oder mindestens einem Teil der Epoxidgruppen, falls vorhanden; und Umsetzen eines Sulfonylisocyanats mit mindestens einem Teil der restlichen Hydroxylgruppen.

2. Verfahren nach Anspruch 1, worin das esterbildende Derivat der Azid-substituierten, aromatischen Carbonsäure das Säurechlorid oder Säureanhydrid ist.

3. Verfahren nach Anspruch 1 oder 2, worin das Polymer ein Poly(vinylacetat) ist oder ein Copolymer von Vinylacetat mit anderen Vinylmonomeren, die zumindest teilverseift wurden, und Estern oder Acetalderivaten dieser verseiften Materialien, ein Epoxyharz, ein Poly(meth)acrylatester, ein Copolymer, das freie Hydroxylgruppen enthält, ein Novolakharz oder ein von Vinylphenolen stammendes Polymer.

4. Verfahren nach Anspruch 1, 2 oder 3, worin die Azidsubstituierte, aromatische Carbonsäure die allgemeine Formel hat:

$$N_3\text{-}R\text{-}(CR^1=CR^2)_a\text{-}(CR^3=CR^4)_b\text{-}COOH$$

worin a und b Null oder 1 sind und a + b mindestens 1 ist; R ein aromatisches Radikal ist, das gegebenenfalls zusätzlich zur Azidogruppe mit ein oder mehreren Gruppen substituiert ist; und $R^1$, $R^2$, $R^3$, und $R^4$, die gleich oder verschieden sein können, Halogenatome, Wasserstoffatome, Cyanogruppen, Alkylgruppen, Arylgruppen, Alkoxygruppen, Aryloxygruppen, Aralkylgruppen oder Aralkoxygruppen sind, vorausgesetzt, daß mindestens eine der Gruppen $R^1$ bis $R^4$ ein Halogenatom oder eine Cyanogruppe ist.

5. Verfahren nach Anspruch 4, worin die Säure ist:
4-Azido-α-brom-δ-chlorcinnamylidenessigsäure
4-Azido-α-chlorcinnamylidenessigsäure
4-Azido-α-cyano-δ-chlorcinnamylidenessigsäure
4-Azido-α-cyanocinnamylidenessigsäure
3-Azido-benzyliden-α-cyanoessigsäure
4-Azido-2-chlorbenzyliden-α-cyanoessigsäure
4-Azido-3,5-dibrombenzyliden-α-cyanoessigsäure
3-Azido-4-methylbenzylidena-α-cyanoessigsäure
3-Azido-4-methoxybenzyliden-α-cyanoessigsäure
4-Azidobenzyliden-α-bromcyanoessigsäure
4-Azidobenzyliden-α-cyanoessigsäure
4-Azido-3-chlorbenzyliden-α-cyanoessigsäure
und eine Azid-substituierte N-Phenylanthranilsäure.

6. Verfahren nach Anspruch 5, worin die mit Azid substituierte N-Phenylanthranilsäure die Formel aufweist:

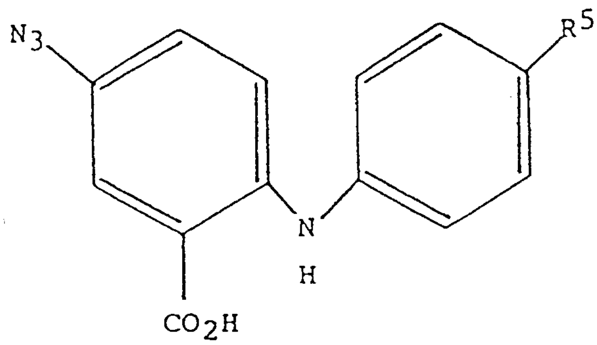

worin $R^5$ Wasserstoff, Methyl, Methoxy oder Chlor ist.

7. Verfahren nach einem der vorstehenden Ansprüche, worin ein Teil der Hydroxylgruppen und/oder Epoxidgruppen mit einer aliphatischen oder aromatischen Carbonsäure, die keine Azidogruppe enthält, umgesetzt wird.

8. Verfahren nach einem der Ansprüche 1 bis 7, worin das Sulfonylisocyanat die allgemeine Formel hat:

$R^6 - SO_2 - N=C=O$

worin $R^6$ eine Alkyl-, Alkoxy-, Aryloxy- oder tertiäre Amingruppe ist, die mit einem Alkyl- oder Acylradikal mit 1 bis 6 C-Atomen oder einem Arylradikal mit 6 bis 10 C-Atomen substituiert ist.

9. Verfahren nach Anspruch 8, worin das Sulfonylisocyanat Benzolsulfonylisocyanat, p-Chlorbenzolsulfonylisocyanat, p-Toluolsulfonylisocyanat und Propenylsulfonylisocyanat ist.

**Revendications**
**Revendications pour les Etats contractants suivants : AT, BE, FR, DE, IT, LU, NL, SE, CH, GB**

1. Polymère sensible aux rayonnements, caractérisé en ce que le polymère comprend une pluralité de groupes ester aromatique substitué par un groupe azido et une pluralité de groupes sulfonyluréthane.

2. Polymère selon la revendication 1, dans lequel les groupes ester aromatique substitué par un groupe azido ont la formule générale:

$N_3\text{-}R\text{-}(CR^1=CR^2)_a\text{-}(CR^3=CR^4)_b\text{-}COO\text{-}$

liée à des atomes de carbone du polymère, dans laquelle a et b sont zéro ou 1 et a + b est au moins égal à 1; R représente un radical aromatique éventuellement substitué par un ou plusieurs groupes en plus du groupe azido; et $R^2$, $R^3$ et $R^4$, qui peuvent être identiques ou différents, représentent des atomes d'halogène, des atomes d'hydrogène, des groupes cyano, des groupes alkyle, des groupes aryle, des groupes alcoxy, des groupes aryloxy, des groupes aralkyle ou des groupes aralcoxy, sous réserve qu'au moins l'un des groupes $R^1$ à $R^4$ représente un atome d'halogène ou un groupe cyano.

3. Polymère selon la revendication 1 ou 2, dans lequel les groupes ester sont dérivés d'un ou plusieurs des acides suivants:
   l'acide 4-azido-α-bromo-δ-chlorocinnamylidène-acétique,
   l'acide 4-azido-α-chlorocinnamylidène-acétique,
   l'acide 4-azido-α-cyano-δ-chlorocinnamylidène-acétique,
   l'acide 4-azido-α-cyanocinnamylidène-acétique,
   l'acide 3-azidobenzylidène-α-cyanoacétique,
   l'acide 4-azido-2-chlorobenzylidène-α-cyanoacétique,
   l'acide 4-azido-3,5-dibromobenzylidène-α-cyanoacétique,
   l'acide 3-azido-4-méthylbenzylidène-α-cyanoacétique,
   l'acide 3-azido-4-méthoxybenzylidène-α-cyanoacétique,

l'acide 4-azidobenzylidène-α-bromocyanoacétique,
l'acide 4-azidobenzylidène-α-cyanoacétique,
l'acide 4-azido-3-chlorobenzylidène-α-cyanoacétique,
et un acide N-phénylanthranilique substitué par un groupe azido.

4. Polymère selon la revendication 3, dans lequel l'acide N-phénylanthranilique substitué par un groupe azido a la formule

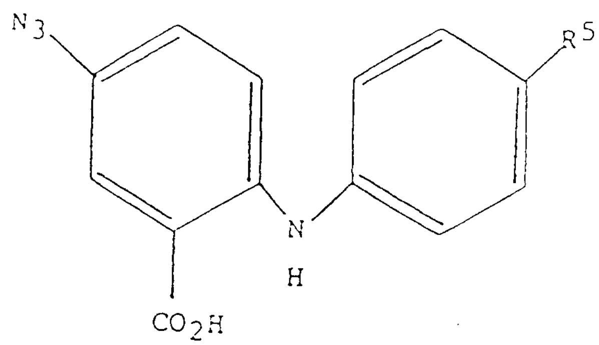

dans laquelle $R^5$ est un hydrogène, un méthyle, un méthoxy ou un chlore.

5. Polymère selon l'une quelconque des revendications 1 à 4, dans lequel le polymère comporte des liaisons à des groupes ester dérivés d'acides carboxyliques aliphatiques ou aromatiques ne contenant pas de groupe azido.

6. Polymère selon l'une quelconque des revendications 1 à 5, dans lequel les groupes sulfonluréthane ont la formule générale

$$R^6-SO_2-NH-\overset{\displaystyle O}{\overset{\|}{C}}-O-$$

liée à des atomes de carbone du polymère, dans laquelle $R^6$ peut être un groupe alkyle, alcoxy, aryloxy ou un groupe amine tertiaire substitué par un radical alkyle ou acyle de 1 à 6 atomes de carbone ou un radical aryle de 6 à 10 atomes de carbone.

7. Polymère selon la revendication 6, dans lequel les groupes sulfonyluréthane sont des groupes dérivés de l'isocyanate de benzènesulfonyle, de l'isocyanate de p-chlorobenzènesulfonyle, de l'isocyanate de p-toluènesulfonyle et de l'isocyanate de propénylsulfonyle.

8. Procédé de production d'un polymère sensible aux rayonnements selon la revendication 1, caractérisé en ce que le procédé comprend la fourniture d'un polymère ayant des groupes hydroxyle et éventuellement des groupes époxy et la réaction d'un acide carboxylique aromatique substitué par un groupe azido, ou d'un de ses dérivés formant des esters, avec certains des groupes hydroxyle et/ou au moins certains des groupes époxy s'il y en a; et la réaction d'un isocyanate de sulfonyle avec au moins certains des groupes hydroxyle restants.

9. Procédé selon la revendication 8, dans lequel le dérivé formateur d'ester de l'acide carboxylique aromatique substitué par un groupe azido est le chlorure d'acide ou l'anhydride d'acide.

10. Procédé selon les revendications 8 ou 9, dans lequel le polymère est un poly(acétate de vinyle) ou un copolymère d'acétate de vinyle avec d'autres monomères vinyliques, et qui ont été au moins partiellement saponifiés, et des esters et des dérivés acétals de ces produits saponifiés, une résine époxy, un poly(ester (méth)acrylique), un copolymère contenant des groupes hydroxyle libres, une résine Novolaque ou un polymère dérivé de vinylphénols.

**11.** Composition sensible aux rayonnements, comprenant un polymère sensible aux rayonnements tel que défini dans l'une quelconque des revendications 1 à 7, et au moins un autre composé sensible aux rayonnements.

**12.** Composition sensible aux rayonnements selon la revendication 11, dans laquelle l'autre composé sensible aux rayonnements est un composé diazoïque ou un composé produit par la condensation d'une diazodiphénylamine et de formaldéhyde.

**Revendications pour l'Etat contractant suivant : ES**

**1.** Procédé de production d'un polymère sensible aux rayonnements, caractérisé en ce que le procédé comprend la fourniture d'un polymère ayant des groupes hydroxyle et éventuellement des groupes époxy et la réaction d'un acide carboxylique aromatique substitué par un groupe azido, ou d'un de ses dérivés formant des esters, avec certains des groupes hydroxyle et/ou au moins certains des groupes époxy s'il y en a; et la réaction d'un isocyanate de sulfonyle avec au moins certains des groupes hydroxyle restants.

**2.** Procédé selon la revendication 1, dans lequel le dérivé formateur d'ester de l'acide carboxylique aromatique substitué par un groupe azido est le chlorure d'acide ou l'anhydride d'acide.

**3.** Procédé selon les revendications 1 ou 2, dans lequel le polymère est un poly(acétate de vinyle) ou un copolymère d'acétate de vinyle avec d'autres monomères vinyliques, et qui ont été au moins partiellement saponifiés, et des esters et des dérivés acétals de ces produits saponifiés, une résine époxy, un poly(ester (méth)acrylique), un copolymère contenant des groupes hydroxyle libres, une résine Novolaque ou un polymère dérivé de vinylphénols.

**4.** Procédé selon la revendication 1, 2 ou 3, dans lequel l'acide carboxylique aromatique substitué par un groupe azido a la formule générale:

$$N_3\text{-}R\text{-}(CR^1=CR^2)_a\text{-}(CR^3=CR^4)_b\text{-}COOH$$

dans laquelle a et b sont zéro ou 1 et a + b est au moins égal à 1; R représente un radical aromatique éventuellement substitué par un ou plusieurs groupes en plus du groupe azido; et $R^1$, $R^2$, $R^3$ et $R^4$, qui peuvent être identiques ou différents, représentent des atomes d'halogène, des atomes d'hydrogène, des groupes cyano, des groupes alkyle, des groupes aryle, des groupes alcoxy, des groupes aryloxy, des groupes aralkyle ou des groupes aralcoxy, sous réserve qu'au moins l'un des groupes $R^1$ à $R^4$ représente un atome d'halogène ou un groupe cyano.

**5.** Procédé selon la revendication 4, dans lequel l'acide est:
l'acide 4-azido-α-bromo-δ-chlorocinnamylidène-acétique,
l'acide 4-azido-α-chlorocinnamylidène-acétique,
l'acide 4-azido-α-cyano-δ-chlorocinnamylidène-acétique,
l'acide 4-azido-α-cyanocinnamylidène-acétique,
l'acide 3-azidobenzylidène-α-cyanoacétique,
l'acide 4-azido-2-chlorobenzylidène-α-cyanoacétique,
l'acide 4-azido-3,5-dibromobenzylidène-α-cyanoacétique,
l'acide 3-azido-4-méthylbenzylidène-α-cyanoacétique,
l'acide 3-azido-4-méthoxybenzylidène-α-cyanoacétique,
l'acide 4-azidobenzylidène-α-bromocyanoacétique,
l'acide 4-azidobenzylidène-α-cyanoacétique,
l'acide 4-azido-3-chlorobenzylidène-α-cyanoacétique,
et un acide N-phénylantbranilique substitué par un groupe azido.

**6.** Procédé selon la revendication 5, dans lequel l'acide N-phénylantbranilique substitué par un groupe azido a la formule

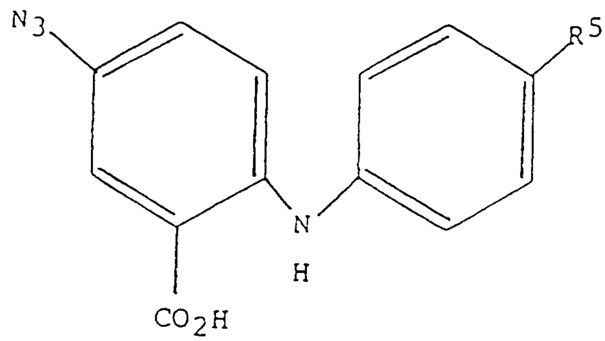

dans laquelle $R^5$ est un hydrogène, un méthyle, un méthoxy ou un chlore.

7. Procédé selon l'une quelconque des revendications précédentes, dans lequel on fait réagir certains des groupes hydroxyle et/ou des groupes époxy avec un acide carboxylique aliphatique ou aromatique ne contenant pas de groupe azido.

8. Procédé selon l'une quelconque des revendications 1 à 7, dans lequel l'isocyanate de sulfonyle a la formule générale

$R^6 - SO_2 - N = C = O$

dans laquelle $R^6$ peut être un groupe alkyle, alcoxy, aryloxy ou un groupe amine tertiaire substitué par un radical alkyle ou acyle de 1 à 6 atomes de carbone ou un radical aryle de 6 à 10 atomes de carbone.

9. Procédé selon la revendication 8, dans lequel l'isocyanate de sulfonyle est l'isocyanate de benzènesulfonyle, l'isocyanate de p-chlorobenzènesulfonyle, l'isocyanate de p-toluènesulfonyle ou l'isocyanate de propénylsulfonyle.